# EUROPEAN PATENT SPECIFICATION

(11) **EP 0 904 603 B1**
(45) Date of publication and mention of the grant of the patent: **10.09.2008**
(21) Application number: 97915797.1
(22) Date of filing: 18.03.1997
(51) Int. Cl.: H01L 29/24, H01L 29/72, H01L 29/78, H01L 21/20

(54) **SiC-based IGBT and MISFET with vertical channel and corresponding manufacturing method**
IGBT und MISFET auf SiC-Basis mit vertikalem Kanal und entsprechendes Herstellungsverfahren
IGBT et MISFET à base de SiC avec un canal vertical et procédé de fabrication correspondant

(30) Priority: 27.03.1996 SE 9601177
(43) Date of publication of application: 31.03.1999
(73) Proprietor: CREE, INC., Durham, NC 27703 (US)
(72) Inventor: HARRIS, Christopher, S-191 72 Sollentuna (SE); KONSTANTINOV, Andrei, S-583 31 Linköping (SE); JANZEN, Erik, S-590 30 Borensberg (SE)
(74) Representative: Olsson, Jan
(86) International application number: PCT/SE1997/000450
(87) International publication number: WO 1997/036315

(56) References cited:
- US-A- 5 237 183

## Description

### TECHNICAL FIELD OF THE INVENTION AND PRIOR ART

The present invention relates to a transistor of SiC according to the preamble of appended claim 1 , as well as a method for producing such a transistor.

Such transistors of SiC may especially be used as switching devices in power applications, where they are very advantageous, owing to the possibility to turn them on and off very fast.

Such transistors made of SiC as semiconductor material are especially well suited for high power applications, since, if it would be possible to fully benefit from the inherent properties of SiC, namely the capability of SiC to function well under extreme conditions, such devices would be superior to devices made of Si for high power applications. Besides the possible high operation temperatures of devices fabricated from SiC and the high thermal conductivity of SiC, SiC also has a more than five times higher breakdown field than Si, so that it is well suited as a material in high power devices operating under conditions where high voltages may occur in the blocking state of a device, and an IGBT made of this material will have particularly low conduction losses in the on-state compared to a MISFET, but the invention comprises also such MISFET's.

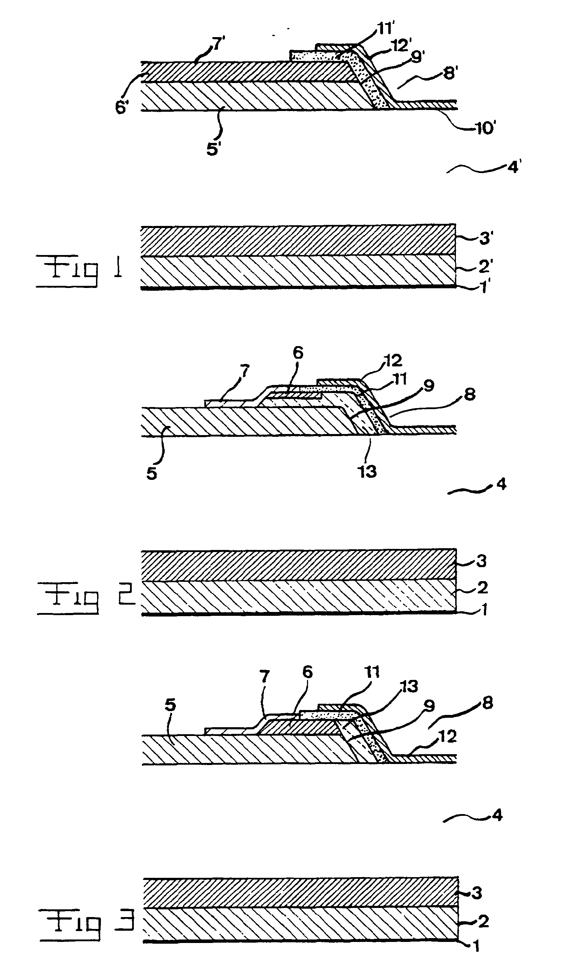

A major example of drawbacks for IGBTs already known arises from the fact that an IGBT has three pn-junctions in series and thereby a thyristor-like structure, which results in problems with so called latch-up in the on-state thereof, and this problem as well as other drawbacks related thereto and also to MISFET's of this type will now be explained while referring to Figure 1 of the appended drawings illustrating a prior art IGBT having superimposed a drain 1', a highly doped p-type substrate layer 2' for forming a good ohmic contact to said drain, a highly doped n-type buffer layer 3', a low doped n-type drift layer 4', a p-type base layer 5', a highly doped n-type source region layer 6' and a source 7'. The device has also a trench 8' carried out through the source region layer and the base layer and into the drift layer, and a wall 9' of the trench is covered with an insulating layer 11', and said insulating layer and the bottom 10' of the trench are covered with a gate electrode 12' on top thereof. By applying a positive voltage above a threshold voltage value to the gate electrode 12' a conducting inversion channel, i.e. an n-type channel, may be created in the base layer 5' at the interface between the base layer 5' and the insulating layer 11' for conduction of electrons from said source region layer 6' to the drift layer 4' and turning the device on. The device may very fast be turned off by cutting off the voltage supply to said gate electrode. This is the normal operation of the IGBT, but this function is only there within a so called safe operating area (SOA), and outside this area the following mechanism will appear. Since an IGBT has a highly doped p-type substrate layer 2', the electron current flowing through said inversion channel and towards the drain will cause a substantial hole injection from the substrate layer 2' into the drift layer 4'. The holes move across the drift layer taking a variety of paths and reach the base layer 5', and they will move towards the source 7' for recombining with electrons from the source. Some of these holes will take paths having a partially lateral extension, and these holes will feel a lateral spreading resistance of the base layer, which in its turn will result in a lateral voltage drop in the base layer along the junction between the base layer 5' and the source region layer 6'. This will tend to forward bias said junction, and if the voltage drop is large enough substantial injection of electrons from the source region layer into the base layer will occur and a parasitic thyristor composed of the two parasitic npn- and pnp-transistors created in this way will latch on and a "latch-up" of the IGBT has then occurred. Once the IGBT is in latchup, the gate no longer has any control of the drain current. The IGBT may then only be turned off in the same way as a conventional thyristor. If the latchup is not terminated quickly, the IGBT will be destroyed by excessive power dissipation. There is a critical value of drain current which will cause a large enough lateral voltage drop to activate said thyristor. Thus, this will mean a severe restriction of the safe operating area of such an IGBT, so that the advantageous features of SiC, especially the ability to withstand high temperatures and the high thermal conductivity thereof, may not be utilized as desired for high power applications.

One possible solution to this problem is to keep the p-base resistance low, i.e. by doping the base layer highly, so that the safe operating area of the device may be extended and higher drain currents may be allowed. However, this solution presents severe problems to the formation of an inversion channel at the interface between the insulating layer and the base layer, since the threshold voltage value to be exceeded will be very high and accordingly limit the charge carrier mobility in said channel and thereby increasing the on-state restistance of the device. A MISFET does not suffer from the latch-up mechanism .described above, however, there is also a trade off in doping level of the p base layer. The restriction of doping density imposed by threshold voltage and channel mobility implies that the base layer is necessarily thicker to support high voltage.

A transistor of the type discussed above and shown in appended Fig 1 is known through US 5 237 183 A.

### SUMMARY OF THE INVENTION

The object of the present invention is to provide a transistor of the type defined in the introduction, in which the drawback mentioned above is reduced to a large extent.

This object is in accordance with the invention obtained by providing such a transistor with the features of appended claim 1.

The low doping concentration of said additional layer, in which a vertical conducting inversion channel will be formed upon applying a voltage to the gate electrode, allows a low necessary gate voltage, i.e. threshold voltage value, to produce the inversion channel. Thus, this low doping implies a higher channel mobility and hence a larger possible forward current. The base layer may therefore be highly doped without any negative influence upon the on-state losses of the device, so that the base layer may be given a low resistivity extending the safe operating area of the device to higher drain currents, i.e. the operation area in which the thyristor action of the device is prevented. These advantages are equally applicable to both an IGBT and a MISFET.

"Highly doped" and "low doped" are in connection with said base layer and said lateral layer, respectively, to be interpreted broadly and cover all cases in which the doping concentration of said lateral layer is substantially lower than the doping concentration of said base layer. Accordingly, these claim definitions only state that this relation is present.

According to another preferred embodiment of the invention said trench extends into said drift layer. This facilitates the proper application of the gate electrode and still ensuring a passivating isolation of the trench bottom.

A further object of the invention is to provide a method for producing a transistor of SiC having an insulated gate and being one of a) a MISFET and b) an IGBT, for which the drawback mentioned of prior art transistors is considerably reduced.

This object is in accordance with the invention obtained by providing such a method comprising the steps according to appended claim 6. An embodiment of this method is defined in appended claim 1.

The use of lateral regrowth in this way to produce said additional low doped layer, in which the conducting channel is created is the key to obtaining a transistor having the preferred properties discussed above. This lateral regrowth also means that the SiC surface forming the interface to the insulating layer is created by epitaxial growth and will thereby have a considerably lower density of traps with respect to prior art transistors having an insulated gate, in which said interface is provided by a surface created through etching, so that the mobility of charge carriers in the channel will be increased and thereby the on-state losses be reduced.

Further advantages and preferred features of the invention will appear from the following description and the other dependent claims.

### BRIEF DESCRIPTION OF THE DRAWING

With reference to the appended drawing, below follows a specific description of preferred embodiments of the invention cited as examples.

In the drawings:
Fig 1 is a schematic cross-section view of an IGBT according to the prior art,
Fig 2 is a cross-section view corresponding to that of Fig 1 of an IGBT according to a first preferred embodiment of the invention, and
Fig 3 is a cross-section view corresponding to Fig 2 of an IGBT according to a second preferred embodiment of the invention.

### DETAILED DESCRIPTION OF PREFERRED EMBODIMENTS OF THE INVENTION

Fig 2 illustrates an insulated gate bipolar transistor (IGBT) according to a first preferred embodiment of the invention, and the parts corresponding to the parts of the prior art transistor described above are provided with the same reference numerals with the index removed, so that the transistor has superimposed a drain 1, a highly doped p-type substrate layer 2 for forming a good ohmic contact to the drain, a highly doped n-type buffer layer 3 arranged for preventing a reach-through of the depletion layer to the substrate layer (this layer is optional), a low dope n-type drift layer 4, a p-type base layer 5, which here is highly doped, a highly doped n-type source region layer 6 and a source 7. A trench 8 is carried out through etching through the source region layer and the base layer and into the drift layer. An additional low dope p-type layer 13 is epitaxially grown, preferably by using the CVD-technique, on a wall 9 of said trench and here also on top of a part of the base layer. The source reigon layer is located on a lateral part of this additional layer, possibly formed by carrying out an implantation step in the additional layer 13. An insulating layer 11, for instance of SiO₂, is applied in the trench on said additional layer 13. Finally, a gate electrode 12, preferably of poly-crystalline silicon, is applied on the insulating layer.

The function of the insulated gate bipolar transistor according to Fig 2 will be as follows: upon application of a voltage over a certain threshold voltage level on the gate electrode 12 a vertical conducting inversion channel will be created at the interface between the additional low doped layer 13 and the insulating layer 11 for transport of electrons between the source region layer 6 and the drift layer 4 and turn the transistor on if a forward bias is applied over the source and drain thereof. Thus, an electron flow from the source 7 to the drain 1 will result. This electron flow will cause hole injection from the substrate layer 2 into the drift layer 4. These holes will try to reach the source for recombining with the electrons thereof. These holes will reach the base layer 5, which thanks to the high doping thereof will have a low resistivity, so that the movement of these holes in partial lateral paths in the base layer will cause only low voltage drops in the lateral direction along the source region layer. Furthermore, only a low positive voltage has to be applied to the gate for creating the inversion channel as a consequence of the low doping of the additional layer 13, in which the inversion channel is created. This means a high mobility in the inversion channel and low on-state losses of the device, which situation is further improved by the fact that the layer 13 is formed by a lateral regrowth, which means that the surface thereof will be of a higher quality, i.e. have a lower trap density, than an etched surface. Accordingly, thanks to the low doping of the additional layer 13 the base layer may be highly doped without causing any problem with a high threshold voltage value.

The doping concentration of the lateral layer 13 may be as low as 10¹⁵ cm⁻³ or even lower and the doping concentration of the base layer may be as high as 10¹⁹-10²¹ cm⁻³, but the invention is not in any way restricted to these figures.

Fig 3 shows an IGBT according to a second preferred embodiment of the invention, which differs from that shown in Fig 2 by the fact that the trench 8 was carried out after the epitaxial growth of the base layer 5 and the source region layer 6 and the layer 13 was then grown on the wall 9 formed by the base layer and the source region layer 6. The rest of the steps for producing this IGBT are the same as for the IGBT according to Fig 2. The function of this IGBT will also be substantially the same as of the one shown in Fig 2, but Fig 3 is only shown for indicating that the embodiment shown in Fig 2 may be varied in different ways within the scope of the invention.

The invention is of course not in any way restricted to the preferred embodiments described above, but many possibilities to modifications thereof will be apparent to a man skilled in the art without departing from the scope of the appended claims.

It is emphasized that the thicknesses of the different layers in the Figures cannot be interpreted as limiting the scope of protection, but any thickness relations are intended to be covered by the claims.

Furthermore, the definition of "superimposed" in the claims is to be interpreted broadly and means that there is a contact in the vertical direction between such subsequent layers.

The dopants used may be of any material suitable as dopants for this application.

The independent patent claims concerning the methods for producing an insulated gate bipolar transistor do of course not include every step necessary for producing such a transistor, but several conventional steps of semiconductor producing technologies will also be used.

"Trench" as defined in the claims only means that a part of the semiconductor layers of SiC is etched away, but this "trench" does not necessarily have to have a bottom with a considerable extension. Furthermore, "vertical" means that the vertical component of the direction in question is substantially larger than the horizontal component.

The number of layers mentioned in the claims is a minimum number, and it is within the scope of the invention to arrange further layers in the devices or dividing any layer into several layers by selective doping of different regions thereof.

"Substrate layer" is in this disclosure to be interpreted as the layer closest to the drain of the layers mentioned and it has not to be a substrate layer in the strict sense of this word within this field, i.e. the layer from which the growth is started. The real substrate layer may be any of the layers and is mostly the thickest one, which may be the drift layer.

The method claims are to be interpreted as not restricted to a growth of the layers located on top of each other in the order they are mentioned, but any other order of growth of these layers is whithin the scope of the claims. For instance, the method may be started from the drift layer and the so called substrate layer and the drain may be grown at the very end of the method.

## Claims

1. A transistor of SiC having an insulated gate and being one of a) a MISFET and b) an IGBT, said transistor comprising superimposed in the order mentioned a drain (1), a highly doped substrate layer (2) being for a) of n-type and for b) of p-type, for b) on top thereof, one of c) a highly doped n-type buffer layer (3) and d) no such buffer layer, a low doped n-type drift layer (4), a p-type base layer (5), a-highly doped n-type source region layer (6) and a source (7), said transistor further comprising a vertical trench (8) extending through the source region layer and the base layer and at least to said drift layer and having a wall (9) next to these layers, said transistor further comprising a gate electrode (12) extending vertically along said lateral wall at least over the vertical extension of said base layer and an insulating layer (11) arranged between the gate electrode and at least said base layer, for, upon applying a voltage to the gate electrode, forming a conducting inversion channel at the interface of the SiC to said insulating layer for electron transport from the source to the drain, **characterized in that** it comprises an additional low doped p-type layer (13) arranged laterally to the base layer (5) connecting it to the insulating layer and extending vertically at least over the extension of the base layer, and that said base layer is highly doped, layers here defined to be low doped having a doping concentration being substantially lower than the doping concentration of layers here defined to be highly doped.

2. A transistor according to claim 1, **characterized in that** said trench (8) extends into said drift layer (4).

3. A transistor according to claim 1 or 2, **characterized in that** said insulating layer (11) and the gate electrode (12) extend over the entire wall (9) of the trench.

4. A transistor according to any of claims 1-3, **characterized in that** said insulating layer (11) covers the entire trench (8).

5. A transistor according to any of claims 1-4, **characterized in that** said additional p-type layer (13) extends vertically over the entire vertical extension of the trench (8).

6. A method for producing a transistor of SiC having an insulated gate and being one of a) a MISFET and b) an IGBT, comprising the steps of:
1) epitaxially growing on top of each other the following semiconductor layers of SiC: a highly doped substrate layer (2) being for a) of n-type and for b) of p-type, for b) on top thereof one of c) a highly doped n-type buffer layer (3) and d) no such buffer layer, a low doped n-type drift layer (4) and highly doped p-type base layer (5),
2) etching at least through said base layer for forming a trench (8) having a wall (9) extending vertically,
3) epitaxially growing an additional low doped p-type layer (13) on said wall at least over the vertical extension of the base layer,
4) one of a) implanting n-type dopants in the additional layer for forming a highly doped n-type source region layer (6) therein and b) epitaxially growing such a source region layer on top of said additional layer,
5) applying an insulating layer (11) with a gate electrode (12) thereon on said additional layer (13) at least over the vertical extension of the base layer and a source (7) on said source region layer, and a drain (1) under said substrate layer (2), layers here defined to be low doped having a doping concentration being substantially lower than the doping concentration of layers here defined to be highly doped.

7. A method according to claim 6, **characterized in that** step 1) also comprises
epitaxially growing on top of said highly doped p-type base layer (5) a highly doped n-type source region layer (6) of SiC, that the etching in step 2) is also carried out
through said source region layer for forming said trench (8).

8. A method according to claim 6 or 7, **characterized in that** said epitaxial growth of the different layers is carried out by using the Chemical Vapour Deposition, CVD, technique.

9. A method according to any of claims 6-8, **characterized in that** said additional layer (13) is grown on the whole wall (9) of the trench (8).

10. A method according to any of claims 6-9, **characterized in that** said etching is carried out so that the vertical trench extends into said drift layer.

## Patentansprüche

1. SiC-Transistor mit einem isolierten Gate, der entweder a) ein MISFET oder b) ein IGBT ist, wobei der Transistor übereinander gelagert in der genannten Reihenfolge einen Drain (1), eine stark dotierte Substratschicht (2), die für a) n-dotiert und für b) p-dotiert ist, für b) darauf entweder c) eine stark dotierte n-Pufferschicht (3) oder d) keine derartige Pufferschicht, eine schwach dotierte n-Driftschicht (4), eine p-Basisschicht (5), eine stark dotierte n-Source-Region-Schicht (6) und eine Source (7) umfasst, wobei der Transistor ferner einen vertikalen Graben (8) umfasst, der durch die Source-Region-Schicht und die Basisschicht und zumindest zur Driftschicht verläuft und eine Wand (9) neben diesen Schichten aufweist, wobei der Transistor ferner eine Gate-Elektrode (12), die vertikal die Seitenwand entlang zumindest über die vertikale Ausdehnung der Basisschicht hinweg verläuft, und eine Isolierschicht (11) umfasst, die zwischen der Gate-Elektrode und zumindest der Basisschicht angeordnet ist, zum Ausbilden, nach dem Anlegen einer Spannung an die Gate-Elektrode, eines leitfähigen Inversionskanals zum Elektronentransport von der Source zum Drain, **dadurch gekennzeichnet, dass** er eine zusätzliche, schwach dotierte p-Schicht (13) umfasst, die seitlich zur Basisschicht (5) angeordnet ist und sie mit der Isolierschicht verbindet und vertikal zumindest über die Ausdehnung der Basisschicht hinweg verläuft, und dass die Basisschicht stark dotiert ist, wobei Schichten, die hier als schwach dotiert definiert sind, eine Dotierungskonzentration aufweisen, die im Wesentlichen niedriger als die Dotierungskonzentration von Schichten ist, die hier als stark dotiert definiert sind.

2. Transistor nach Anspruch 1, **dadurch gekennzeichnet, dass** der Graben (8) in die Driftschicht (4) hinein verläuft.

3. Transistor nach einem der Ansprüche 1 oder 2, **dadurch gekennzeichnet, dass** die Isolierschicht (11) und die Gate-Elektrode (12) über die gesamte Wand (9) des Grabens hinweg verlaufen.

4. Transistor nach einem der Ansprüche 1 bis 3, **dadurch gekennzeichnet, dass** die Isolierschicht (11) den gesamten Graben (8) abdeckt.

5. Transistor nach einem der Ansprüche 1 bis 4, **dadurch gekennzeichnet, dass** die zusätzliche p-Schicht (13) vertikal über die gesamte vertikale Ausdehnung des Grabens (8) hinweg verläuft.

6. Verfahren zum Erzeugen eines SiC-Transistors mit einem isolierten Gate, der entweder a) ein MISFET oder b) ein IGBT ist, folgende Schritte umfassend:
1) epitaktisches Aufwachsen aufeinander der folgenden SiC-Halbleiterschichten: eine stark dotierte Substratschicht (2), die für a) n-dotiert und für b) p-dotiert ist, für b) darauf entweder c) eine stark dotierte n-Pufferschicht (3) oder d) keine derartige Pufferschicht, eine schwach dotierte n-Driftschicht (4), eine p-Basisschicht (5),
2) Ätzen durch zumindest die Basisschicht zum Ausbilden eines Grabens (8) mit einer vertikal verlaufenden Wand (9),
3) epitaktisches Aufwachsen einer zusätzlichen, schwach dotierten p-Schicht (13) auf der Wand zumindest über die vertikale Ausdehnung der Basicschicht hinweg,
4) entweder a) Implantieren von n-Dotierstoffen in der zusätzlichen Schicht zum Ausbilden einer stark dotierten n-Source-Region-Schicht (6) darin oder b) epitaktisches Aufwachsen einer derartigen Source-Region-Schicht auf der zusätzlichen Schicht,
5) Aufbringen einer Isolierschicht (11) mit einer Gate-Elektrode (12) darauf auf die zusätzliche Schicht zumindest über die vertikale Ausdehnung der Basisschicht hinweg und eine Source (7) auf der Source-Region-Schicht und einen Drain (1) unter der Substratschicht (2), wobei Schichten, die hier als schwach dotiert definiert sind, eine Dotierungskonzentration aufweisen, die im Wesentlichen niedriger als die Dotierungskonzentration von Schichten ist, die hier als stark dotiert definiert sind.

7. Verfahren nach Anspruch 6, **dadurch gekennzeichnet, dass** Schritt 1) außerdem das epitaktische Aufwachsen auf der stark dotierten p-Basisschicht (5) einer stark dotierten n-Source-Region-Schicht (6) aus SiC umfasst, dass das Ätzen in Schritt 2) außerdem durch die Source-Region-Schicht zum Ausbilden des Grabens (8) ausgeführt wird.

8. Verfahren nach einem der Ansprüche 6 oder 7, **dadurch gekennzeichnet, dass** das epitaktische Aufwachsen der verschiedenen Schichten unter Nutzung der chemischen Gasphasenabscheidung, CVD, erfolgt.

9. Verfahren nach einem der Ansprüche 6 bis 8, **dadurch gekennzeichnet, dass** die zusätzliche Schicht (13) auf der gesamten Wand (9) des Grabens (8) aufgewachsen wird.

10. Verfahren nach einem der Ansprüche 6 bis 9, **dadurch gekennzeichnet, dass** das Ätzen derart ausgeführt wird, dass der vertikale Graben in die Driftschicht hinein verläuft.

## Revendications

1. Transistor de carbure de silicium (SiC) ayant une porte isolée et étant soit a) un MISFET soit b) un IGBT, le dit transistor comprenant, superposés dans l'ordre mentionné un drain (1), une couche de substrat hautement dopé (2) étant pour a) de type n et pour b) de type p, pour b) sur le sommet de celle-ci, une de c) une couche (3) de tampon hautement dopé de type n et d) aucune couche de tampon de ce type, une couche (4) de dérivation faiblement dopée de type n, une couche de base de type p (5), une couche (6) de région source hautement dopée de type n et une source (7), le dit transistor comprenant de plus un sillon vertical (8) s'étendant à travers la couche de région source et la couche de base et au moins jusqu'à la couche de dérivation et ayant une paroi (9) à côté de ces couches, le dit transistor comprenant de plus une électrode de porte (12) s'étendant verticalement le long de la dite paroi latérale au moins par-dessus l'extension verticale de la dite couche de base et une couche d'isolation (11) placée entre l'électrode de porte et au moins la dite couche de base, pour, au moment de l'application d'une tension à l'électrode de porte, un canal d'inversion conducteur au niveau de l'interface du SiC pour former la dite couche d'isolation pour le transport des électrons de la source au drain, **caractérisé en ce qu'**il comprend une couche supplémentaire (13) de type p faiblement dopée placée latéralement par rapport à la couche de base (5) la connectant à la couche d'isolation et s'étendant verticalement au moins par-dessus l'extension de la couche de base, et **en ce que** la dite couche de base est hautement dopée, les couches ici définies comme étant faiblement dopées ayant une concentration de dopage significativement plus basse que la concentration de dopage des couches ici définies comme étant hautement dopées.

2. Transistor selon la revendication 1, **caractérisé en ce que** le dit sillon (8) s'étend dans la dite couche de dérivation (4).

3. Transistor selon la revendication 1 ou 2, **caractérisé en ce que** la dite couche d'isolation (11) et l'électrode de porte (12) s'étendent sur toute la paroi (9) du sillon.

4. Transistor selon l'une quelconque des revendications 1 à 3, **caractérisé en ce que** la dite couche d'isolation (11) recouvre entièrement le sillon (8).

5. Transistor selon l'une quelconque des revendications 1 à 4, **caractérisé en ce que** la dite couche supplémentaire (13) de type p s'étend verticalement par-dessus l'extension verticale entière du sillon (8).

6. Méthode de production d'un transistor SiC ayant une porte isolée et étant soit a) un MISFET soit b) un IGBT, comprenant les étapes de :
1. faire croître épitaxialement l'une sur l'autre les couches semi-conductrices suivantes de SiC : une couche de substrat hautement dopé (2) étant pour a) de type n et pour b) de type p, pour b) sur celles-ci soit c) une couche tampon de type n hautement dopé (3) soit d) aucune couche tampon de ce type, une couche de dérivation faiblement dopée (4) et une couche de base de type p hautement dopée (5),
2. attaquer chimiquement au moins la dite couche de base pour former un sillon (8) ayant une paroi (9) s'étendant verticalement,
3. faire croître épitaxialement une couche supplémentaire de type p faiblement dopée (13) sur la dite paroi au moins sur l'extension verticale de la couche de base,
4. soit a) implanter des dopants de type n dans la couche supplémentaire pour y former une couche (6) de région source de type n hautement dopée et b) faire croître épitaxialement une telle couche de région source sur la dite couche supplémentaire,
5. appliquer une couche isolante (11) avec une électrode de porte (12) dessus sur la dite couche supplémentaire (13) au moins sur l'extension verticale de la couche de base et une source (7) sur la dite couche de région source, et un drain (1) sous la dite couche de substrat (2), les couches ici définies comme étant faiblement dopées ayant une concentration de dopant significativement plus basse que la concentration de dopant des couches ici définies comme étant hautement dopées

7. Méthode selon la revendication 6, **caractérisée en ce que** l'étape 1) comprend également de faire croître épitaxialement sur la dite couche de base de type p hautement dopée (5) une couche (6) de région source de type n hautement dopée de SiC, et **en ce que** l'attaque chimique de l'étape 2) est également réalisée à travers la dite couche de région source pour former le dit sillon (8).

8. Méthode selon la revendication 6 ou 7, **caractérisée en ce que** la dite croissance épitaxiale des différentes couches est réalisée en utilisant la technique de dépôt chimique, CVD, en phase vapeur.

9. Méthode selon l'une quelconque des revendications 6 à 8, **caractérisée en ce que** la dite couche supplémentaire (13) croit sur la paroi (9) entière du dit sillon (8).

10. Méthode selon l'une quelconque des revendications 6 à 9, **caractérisée en ce que** la dite attaque chimique est réalisée de manière à ce que le sillon vertical s'étende dans la dite couche de dérivation.
